(19) Europäisches Patentamt / European Patent Office / Office européen des brevets

(11) **EP 2 113 587 B1**

(12) **EUROPÄISCHE PATENTSCHRIFT**

(45) Veröffentlichungstag und Bekanntmachung des Hinweises auf die Patenterteilung:
**20.04.2011 Patentblatt 2011/16**

(51) Int Cl.:
*C25D 3/38* *(2006.01)*    *H05K 3/24* *(2006.01)*
*H05K 3/42* *(2006.01)*    *C25D 5/18* *(2006.01)*

(21) Anmeldenummer: **08008111.0**

(22) Anmeldetag: **28.04.2008**

(54) **Wässriges saures Bad und Verfahren zum elektrolytischen Abschneiden von Kupfer**

Aqueous acidic bath and method for electroplating copper

Bain acide aqueux et procédé de dépôt électrolytique du cuivre

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**04.11.2009 Patentblatt 2009/45**

(73) Patentinhaber: **ATOTECH Deutschland GmbH**
**10553 Berlin (DE)**

(72) Erfinder:
• **Brunner, Heiko, Dr.**
**10243 Berlin (DE)**
• **Roelfs, Bernd**
**10179 Berlin (DE)**

• **Rohde, Dirk**
**10553 Berlin (DE)**
• **Pliet, Thomas**
**10407 Berlin (DE)**

(74) Vertreter: **Bressel, Burkhard**
**Bressel und Partner**
**Patentanwälte**
**Park Kolonnaden**
**Potsdamer Platz 10**
**10785 Berlin (DE)**

(56) Entgegenhaltungen:
**GB-A- 1 107 198      US-A- 2 876 178**
**US-A- 3 111 465      US-A- 5 215 645**
**US-A- 5 972 192      US-A1- 2002 195 351**
**US-B1- 6 261 433**

EP 2 113 587 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein wässriges saures Bad und ein Verfahren zum elektrolytischen Abscheiden von Kupfer, insbesondere zum Füllen von Blind Micro Vias (BMVs), Through Vias, Trenches und ähnlichen Strukturen auf Leiterplatten, Chip Carriem und Wafern.

Es ist bekannt, sauren elektrolytischen Kupferbädem zahlreiche verschiedene organische Zusatzstoffe zuzugeben. Damit können dekorative und funktionelle Eigenschaften der Kupferüberzüge gesteuert werden. Vor allem werden den Bädern Glanzbildner (Brightener) und Glanzträger (Carrier) zugegeben, um glänzende Schichten zu erhalten. Außerdem werden bei der Herstellung von Leiterplatten, Chip Carriern und Halbleiterwafem organische Verbindungen als Zusatzstoffe zu Verlcupferungsbädern eingesetzt, die als Einebner (Leveler) dienen und die eine möglichst gleichmäßige Abscheidung von Kupfer in und auf verschiedenen Bereichen der Leiterplattenoberfläche bzw. der Leiterplattenstruktur, z.B. den Trenches oder den BMV, ermöglichen sollen.

Die gleichmäßige Abscheidung von Kupfer ist auf Grund der geometrischen Anordnung und Ausbildung der einzelnen Bereiche insbesondere in Trenches, BMVs oder Through Vias oft schwierig, da diese Bereiche ein unterschiedliches elektrisches Abscheideverhalten zeigen. Insbesondere in sehr kleinen derartigen Strukturen (im mittleren bis unteren µm-Bereich) werden Einflüsse der Diffusion der Metallionen und der Additive zur Abscheidestelle dominant. Eine gleichmäßige Abscheidung von Kupfer ist die Voraussetzung für den Aufbau von komplexen Leiterstrukturen. Andernfalls kann es passieren, dass beispielsweise an den Wänden der Through Vias keine ausreichende oder eine übermäßige Abscheidung erfolgt, was zu deren Unbrauchbarkeit und damit zum Ausschuss der gesamten Leiterplatte oder des Chip Carriers führt. Zum gleichen Ergebnis führt eine unzureichende und ungleichmäßige Metallisierung der Trenches und BMVs an Leiterplatten, Chip Carriern und Wafern, da sich in den sehr kleinen Strukturen, die mit dem Metall vollständig gefüllt werden sollen, Hohlräume (Voids) im Kupferniederschlag bilden oder sich die Strukturen nach dem Verkupfern auf der Oberfläche durch Unebenheiten abbilden können. Dadurch werden zusätzliche Arbeitsschritte und Materialkosten beim Aufbau nachfolgender Schichten erforderlich und können Probleme durch nicht mehr tolerierbare Impedanzschwanken entstehen.

In US-Patent Nr. 2,876,178 ist ein basisches cyanidisches Kupferbad beschrieben, In dem Aminosäuren oder sekundäre Aminosäurederivate, wie Peptone und Peptide, enthalten sind. Diese Additive sollen vorteilhafte Wirkungen für die Kupferabscheidung haben.

Das US-Patent_Nr. 5.972.192 offenbart ein wässriges saures Bad zur elektrolytischen Abscheidung von Kupfer, das eine Kupferionenquelle, eine Säureionenquelle, eine Briahtener-Verbindung und eine Leveler-Verbindung enthält, wobei als Leveler-Verbindung uunter anderem Polyethylenimin oder Polyglycin verwendet werden.

In US-Patent Nr. 6.261.433 ist ein Kupferelektrolyt offenbart, der neben Kupfer eine Säure sowie als Additive Leveler-, Brightener- und Grain Refiner-Verbindungen enthält Als geeignete Additive werden unter anderem das Dipeptid Beta-alanyl-Hystidin. Diglycin und Triglycin angegegeben.

In US-Patent Nr. 5,215,645 ist ein Kupferbad zum elektrolytischen Bilden einer Kupferfolie zur Verwendung beim Aufbau einer Leiterplatte beschrieben. Das Kupferbad enthält neben anderen Zusätzen Gelatine-Verbindungen. Derartige Verbindungen werden als hochpolymere Proteine von Aminosäuren mit einem Molekulargewicht von 10.000 bis 300.000 beschrieben. Gelative-Additive werden gemäß der Beschreibungseinleitung in diesem Dokument zur Kontrolle der Rauheit des abgeschiedenen Kupferüberzuges verwendet. Zusätzlich ist eine aktive Schwefelverbindung enthalten, vorzugsweise Thioharnstoff, um die Rauheit des abgeschiedenen Kupfers zu begrenzen.

Auch in US 2004/0188263 A1 ist die Erzeugung einer Kupferfolie für die Herstellung von Leiterplatten mittels eines Kupferbades beschrieben. Das hierfür verwendete Bad enthält u.a Leim, Gelatine und Kollagenpeptide. Die gebildete Kupferfolie ermöglicht die einfachere Einbringung von mit einem Laser gebohrten Löchern beim Leiterplattenaufbau durch die Kupferfolie hindurch, ohne dass z.B. eine Nickelmetall-Hilfsschicht benötigt wird.

Auch die Herstellung von leistungsfähigeren integrierten Schaltungen für IC-Chips fordert den Einsatz leistungsfähigerer Kupferabscheidebäder mit entsprechenden Badzusätzen, wobei einige der oben genannten Anforderungen noch stärker zum Tragen kommen. In P.M.Vereecken et al.:"The chemistry of additives in damascene copper plating", IBM J. Res. & Dev., Vol. 49 (Jan. 2005), No. 1,3-18, sind Zusammensetzungen beschrieben, enthaltend beispielsweise Polyether, auf Schwefel basierende organische Verbindungen und Leveler, wie Thioharnstoff. Benzotriazol (BTA) und Janus Grün B (JGB), mit welchen spiegelähnliche Kupferoberflächen erzeugt werden können und die eine beschleunigte Kupferabscheidung in feinsten Trenches ermöglichen.

In US 2002/0195351 A1 ist eine Zusammensetzung für die elektrolytische Abscheidung von Kupfer auf integrierten Schaltkreisen, beispielsweise in schmalen Trenches für Leiterbahnen oder Leiterbahnverbindungen (Vias) offenbart. Die Zusammensetzung enthält neben anderen Zusätzen schwefelhaltige Aminosäuren als Poliermittel, beispielsweise Cystein, Percystein, Glutathion, deren Derivate und Salze.

Mit der fortschreitenden Miniaturisierung von Leiterplatten bzw. dem komplexer werdenden Aufbau von Leiterplatten und Wafern, unter anderem mit dem Ziel größere Rechenkapazitäten bereitzustellen und/oder Funktonalitäten auf immer kleinerem Raum zur Verfügung zu stellen, steht die Industrie vor immer neuen Herausforderungen. Dabei wird die Geometrie beispielsweise der Leiterplatten bzw. der Leiterbahnstrukturen sowie der Leiterstrukturen auf Leiterplatten, Chip Carriern und Halbleiterwafern immer komplizierter. Beispielsweise wird das Verhältnis von Kupferdicke zur Breite einer Leiterbahn bzw. der Lochtiefe zum Lochdurchmesser (Aspektverhältnis) stetig größer, da die Lochdurchmesser immer kleiner und die Leiterbahnen immer schmaler werden,

Insbesondere hat es sich gezeigt, dass die Gleichmäßigkeit der Metallabscheidung mit den bekannten Verfahren auf Leiterplatten, Chip Carriern und Halbleiterwafern nicht ausreichend ist, um eine sichere Erzeugung der Leiterstrukturen in Trenches und Vias zu gewährleisten. Durch die immer kleiner werdenden Strukturen wird beim Abscheiden von Kupfer eine Kupferschicht mit unebener Oberfläche gebildet. Dies führt beim Damaszenerverfahren zur Erzeugung der Leiterstrukturen dazu, dass ein verlässliches Ergebnis beim chemisch-mechanischen Polieren nicht mehr ohne weiteres erreicht werden kann. Denn bei diesem Verfahrensschritt wird vorausgesetzt, dass die beim elektrolytischen Abscheiden erzeugten Kupferoberflächen weitgehend glatt und eben sind, um einen sicheren Abtrag bis zu der gewünschten Tiefe zu erreichen. Außerdem stellt sich heraus, dass die gewünschten Wirkungen nicht mit der erforderlichen Reproduzierbarkeit eintreten.

Um diesen Anforderungen gerecht zu werden, werden Badlösungen zum akkurat gleichmäßigen Abscheiden von Kupfer benötigt, die diese Wirkung auch reproduzierbar erbringen. Insbesondere werden Badlösungen gesucht, die geeignet sind, Trenches und BMVs derart zu füllen, dass die gebildeten Leiterstrukturen eine gleichmäßige Schichtdickenverteilung und gute Leitfähigkeit zeigen, dass also die gebildeten Leiterbahnen keine sogenannte Ski Slope-Form (konkave Form der Kupferoberfläche im Querschnitt entsprechend der Rundung einer Skispitze) und auch keine anderen konkaven Strukturen und die BMVs keine sogenannte Dimple-Form (Einsenkung der Kupferoberfläche an der Stelle des Vias) aufweisen. Dabei dürfen sich außerdem die Fülleigenschaften der Badlösungen, wie insbesondere die Mikrostreuung, nicht verschlechtern.

Mit den vorgenannten Kupferbadlösungen können die genannten Anforderungen nicht erfüllt werden. Insbesondere kann eine gleichmäßige Schichtdickenverteilung des abgeschiedenen Kupfers insbesondere in Trenches und BMVs nicht und jedenfalls nicht reproduzierbar erreicht werden.

Der vorliegenden Erfindung liegt von daher das Problem zugrunde, dass die bekannten Badlösungen nicht geeignet sind, kleinste Strukturen von Durchgangslöchern, Trenches und BMVs mit der ausreichenden Präzision gleichmäßig, d.h. mit einer möglichst ebenen Kupferoberfläche, zu füllen. Der vorliegenden Erfindung liegt von daher die Aufgabe zugrunde, diese Probleme zu lösen und darüber hinaus zu gewährleisten, dass die genannten Anforderungen auch unter Bedingungen der Massenproduktion konstant erreichbar sind.

Insbesondere sollen kleinste Strukturen, wie Durchgangslöcher, Trenches und BMVs, auf Leiterplatten. Chip Carriern und Halbleiterwafem so gefüllt werden, dass sich keine nachteiligen Effekte, wie Ski-Slope und Dimple, einstellen und dass sich insgesamt eine ebene Oberfläche mit gleichmäßiger Schichtdicke ergibt.

Die Aufgabe wird gelöst durch ein wässriges saures Bad zur elektrolytischen Abscheidung von Kupfer, das mindestens eine Kupferionenquelle, mindestens eine Säureionenquelle, mindestens eine Brightener-Verbindung, die ausgewählt ist aus der Gruppe umfassend organische Thiol-, Sulfid-, Disulfid- und Polysulfid-Verbindungen, und mindestens eine Leveler-Verbindung enthält, wobei mindestens eine Leveler-Verbindung ausgewählt ist aus der Gruppe, umfassend synthetisch hergestellte funktionalisierte Aminosäuren und synthetisch hergestellte funktionalisierte Peptide, und dass die Peptide und/oder Aminosäuren mit Polyalkylenglykol- und/oder mit Polyalkylenimin- und/oder mit Polyvinylalkohol-Gruppen funktionalisiert sind.

Die Aufgabe wird ferner gelöst durch ein Verfahren zum elektrolytischen Abscheiden von Kupfer auf einem Werkstück, das die folgenden Verfahrensschritte umfasst: (i) Bereitstellen des erfindungsgemäßen wässrigen sauren Bades zum elektrolytischen Abscheiden von Kupfer sowie mindestens eine Anode, (ii) In-Kontakt-Bringen des Werkstückes und mindestens einer Anode mit dem erfindungsgemäßen wässrigen sauren Bad und (iii) Erzeugen eines elektrischen Stromflusses zwischen dem Werkstück und mindestens einer Anode, so dass Kupfer auf dem Werkstück abgeschieden wird. Dies wird dadurch bewerkstelligt, dass das Werkstück und mindestens eine Anode mit einer Strom- bzw. Spannungsquelle verbunden werden.

Das erfindungsgemäße wässrige saure Bad und das erfindungsgemäße Verfahren werden vorzugsweise bei der elektrolytischen Beschichtung von Leiterplatten, Chip Carriem und Halbleiterwafern oder auch beliebigen anderen Schaltungsträgern angewendet und dienen insbesondere in Halbleiterwafern, aber auch in Leiterplatten und Chip Carriern dazu, Trenches, Blind Micro Vias, Through Vias (Durchgangslöcher) und ähnliche Strukturen mit Kupfer zu füllen.

Soweit in dieser Beschreibung und in den Ansprüchen der Begriff "Aminosäure" verwendet wird, so ist darunter eine Verbindung zu verstehen, die mindestens eine Aminogruppe und mindestens eine Carboxylgruppe aufweist. Dabei handelt es sich sowohl um proteinogene Aminosäuren ($\alpha$-Aminocarbonsäuren) als auch um nicht-proteinogene Aminosäuren. Die Aminosäuren können unabhängig voneinander in S- oder L-Konfiguration vorkommen. Es können u.a folgende Aminosäuren vorkommen, Alanin, Arginin, Asparagin. Asparaginsäure, Cystein, Glutaminsäure, Glutamin, Glycin, Histidin, Isoleucin, Leucin, Lysin, Methionin, Phenylalanin, Prolin, Serin, Threonin, Tryptophan, Tyrosin, Valin. Ferner können die Aminosäuren auch unabhängig von einander derivatisiert, insbesondere methyliert, sein oder beispielsweise Schutzgruppen tragen. Als Aminosäure ist jedoch keine Verbindung verstehen, die im Molekül über eine Peptid-(NH-CO)-Bindung verfügt.

Soweit in dieser Beschreibung und in den Ansprüchen der Begriff "Peptid" verwendet wird, so ist darunter eine geradkettige oder verzweigtkettige (auch sternförmige) Aminosäurekette mit mindestens zwei Aminosäureeinheiten zu verstehen, die über eine Peptid- (NH-CO)-Bindung miteinander verknüpft sind. Die Aminosäuren können in der Kette in jeder beliebigen Reihenfolge, Konfiguration und Häufigkeit vorkommen. Soweit in der Beschreibung der Begriff "unfunktionalisiertes Peptid" verwendet wird, so ist darunter ein Peptid zu verstehen, das nicht mit einem Polyalkylenglykol- oder mit einem Polyalkylenimin- oder mit einem Polyvinylalkohol-Rest und auch mit keinem anderen Rest funktionalisiert ist. Soweit in der Beschreibung und in den Ansprüchen der Begriff "funktionalisiertes Peptid" oder "funktionalisierte Aminosäure" verwendet wird, ist darunter ein Peptid bzw. eine Aminosäure zu verstehen, die mit einer polyalkylenglykol- und/oder mit einer Polyalkylenimin- und/oder mit einer Polyvinylalkohol-Gruppe funktionalisiert ist, wobei die Gruppe eine Wirkung im Hinblick auf die Leveler-Verbindung hat, beispielsweise eine verbesserte Leveling-Wirkung und/oder eine Erhöhung der Löslichkeit der Leveler-Verbindung in dem wässrigen sauren Bad.

Soweit in dieser Beschreibung und in den Ansprüchen der Begriff "Oligopeptid" verwendet wird, so ist darunter ein Peptid zu verstehen, das aus bis zu zehn Aminosäuren besteht, die untereinander über Peptidbindungen verknüpft sind. Somit sind unter Oligopeptiden insbesondere Dipeptide, Tripeptide, Tetrapeptide, aber auch höhere Peptidhomologe zu verstehen. Oligopeptide grenzen sich gegenüber Polypeptide durch die Kettenlänge ab: Bis zu 10 Aminosäuren lange Peptide sind den Oligopeptiden zuzurechnen, während über 10 Aminosäuren lange Peptide als Polypeptide anzusehen sind.

Soweit in dieser Beschreibung und in den Ansprüchen der Begriff "Polypeptid verwendet wird, so ist darunter ein Peptid zu verstehen, das aus über zehn bis zu beispielsweise 100 Aminosäuren besteht, die über Peptidbindungen miteinander verknüpft sind.

Peptide können nach anerkannten Methoden der Chemie hergestellt werden. Der Fachmann kennt derartige Herstellungsverfahren. Erfindungsgemäß werden die funktionalisierten Peptide und funktionalisierten Aminosäuren durch Synthese hergestellt. Derartige Verfahren sind auf dem Fachgebiet gut bekannt (siehe beispielsweise F. Albericio "Developments in peptide and amide synthesis", Current Opinion in Chemical Biology 8 (2004) 211-221). Insofern wird der Inhalt dieser Veröffentlichung durch Inbezugnahme in den vorliegenden Offenbarungsgehalt aufgenommen.

Soweit in dieser Beschreibung und in den Ansprüchen der Begriff "Alkyl" verwendet wird, so ist darunter ein Kohlenwasserstoffradikal mit der allgemeinen chemischen Formel $C_nH_{2n+1}$, zu verstehen, wobei n eine ganze Zahl von 1 bis 50 ist. $C_1$-$C_8$ beispielsweise umfasst u.a. Methyl, Ethyl, n-Propyl, iso-Propyl, n-Butyl, iso-Butyl, tert-Butyl, n-Pentyl, iso-Pentyl, sec-Pentyl, tert-Pentyl, neo-Pentyl, Hexyl, Heptyl, Octyl. Alkyl kann unter Ersetzung jeweils eines H-Atoms durch eine funktionelle Gruppe, beispielsweise OH, Hal (F, CI, Br, I), CHO, COOH, COOR u.a., substituiert sein.

Soweit in dieser Beschreibung und in den Ansprüchen der Begriff "Aryl" verwendet wird, so ist darunter ein ringförmiges aromatisches Kohlenwasserstoff-Radikal zu verstehen, beispielsweise Phenyl oder Naphthyl, bei dem einzelne Ringkohlenstoffatome durch N, O und/oder S ersetzt sein können, beispielsweise Benzthiazolyl. Darüber hinaus kann Aryl unter Ersetzung jeweils eines H-Atoms durch eine funktionelle Gruppe, beispielsweise OH, Hal (F, CI, Br. 1), CHO, COOH, COOR u.a., substituiert sein.

Soweit in dieser Beschreibung und in den Ansprüchen der Begriff "Glanzbildner (Brightener) verwendet wird, so sind darunter Stoffe zu verstehen, die eine glanzbildende und inhibierende Wirkung bei der Kupferabscheidung ausüben. Es handelt sich dabei um organische Thiole, Sulfide, Disulfide oder Polysulfide, beispielsweise um aliphatische Thiole, Sulfide, Disulfide und Polysulfide. Damit diese Verbindungen eine ausreichende Löslichkeit in dem wässrigen sauren Bad haben, enthalten sie vorzugsweise zusätzlich jeweils mindestens eine polare Gruppe, beispielsweise eine oder zwei Sulfonsäuregruppen bzw. deren Salzgruppen.

Soweit in dieser Beschreibung und in den Ansprüchen der Begriff "Glanzträger" (Carrier) verwendet wird, so sind darunter Stoffe zu verstehen, die eine die Kupferabscheidung fördernde Wirkung ausüben. Es handelt sich dabei im Allgemeinen um organische Verbindungen, insbesondere Sauerstoff enthaltende hochmolekulare Verbindungen, vorzugsweise um Polyalkylenglykol-Verbindungen.

Interessanterweise hat es sich herausgestellt, dass unfunktionalisierte Aminosäuren keine einebnende Wirkung haben. Wenn anstelle von Aminosäuren die synthetisch hergestellten funktionalisierten Peptide und synthetisch hergestellten funktionalisierten Aminosäuren eingesetzt werden, die mit Polyalkylenglykol- und/oder mit Polyalkylenimin- und/oder mit Polyvinylalkohol-Gruppen funktionalisiert sind, stellt sich in überraschender Weise ein völlig anderes Verhalten ein. Dabei wird dann je nach Kettenlänge und Typ der Aminosäure in den Peptiden eine einebnende Wirkung bis hin zur Auffüllung von Blind Micro Vias und ähnlichen Strukturen beobachtet. Über die Kettenlänge und auch den Kettentyp können dann gezielt Eigenschaften variiert werden. Die Herstellung von Addukten aus Peptiden und PEG und deren positive Wirkung in therapeutischen und biotechnologischen Anwendungen ist zum Beispiel von F. M. Veronese beschrieben ("Peptide and protein PEGylation: a review of problems and solutions", Biomaterials 22 (2001) 405-417). Insofern wird der Inhalt dieser Veröffentlichung durch Inbezugnahme in den vorliegenden Offenbarungsgehalt aufgenommen.

Mit dem erfindungsgemäßen wässrigen sauren Bad und dem erfindungsgemäßen Verfahren ist es möglich, Kupfer in Vertiefungen mit sehr kleinen Strukturabmessungen mit Strukturbreiten von etwa 50 μm und kleiner, beispielsweise in Trenches und BMVs, sehr gleichmäßig abzuscheiden. Insbesondere ist es möglich, diese Vertiefungen vollständig und ohne Hohlräume zu füllen, Dabei ist gewährleistet, dass sich eine Kupferoberfläche bildet, die weitgehend glatt und eben ist und praktisch keine Verformungen zeigt. Beispielsweise sind Einsenkungen (Dimple) im Bereich von BMVs kaum noch zu beobachten, und eine ungleichmäßige Form der Leiterstrukturen in Trenches in Form eines Ski slope wird vollständig unterdrückt, so dass sich im Querschnitt der Leiterstruktur eine ideale oder zumindest nahezu ideale rechteckige Form ergibt. Dies wird dadurch erreicht, dass Kupfer in den Trenches mit ebener Oberfläche abgeschieden wird.

Gegenüber den bekannten Bädern zum elektrolytischen Abscheiden von Kupfer, beispielsweise den aus US-Patent Nr. 2,876,178, US-Patent Nr. 5,215,645. und US 2004/0188263 A1 bekannten Bädern, bei denen aus tierischen Produkten gewonnene Additive verwendet werden (beispielsweise Hydrolyseprodukte aus Kollagen, Gel bildenden Albuminoiden, Fibroiden, Keratinen (US-Patent Nr. 2,876,178), Gelatine, üblicherweise aus tierischem Knochenleim gewonnen (US-Patent Nr. 5,215,645), Leim, Gelatine oder Kollagenpeptid (US 200410188263 A1)), enthält das erfindungsgemäße wässrige saure Bad synthetisch hergestellte funktionalisierte Peptide und/oder synthetisch hergestellte funktionalisierte Aminosäuren, die mit Polyalkylenglykol- und/oder mit Polyalkylenimin- und/oder mit Polyvinylalkohol-Gruppen funktionalisiert sind. Synthetisch hergestellte Stoffe weisen eine definierte Stoffdentität und -zusammensetzung auf, während die Additive in den bekannten Bädern Gemische unterschiedlicher Verbindungen sind. Deren Identität und Zusammensetzung sind kaum bekannt und daher undefiniert. Insbesondere können sich je nach Gewinnungs- bzw. Aufbereitungsmethode sowie Quelle für diese Stoffe unterschiedliche Stoffzusammensetzungen ergeben, beispielsweise schon in unterschiedlichen Chargen. Da die einzelnen Stoffe je nach Aufbau und Zusammensetzungen zudem unterschiedliche Eigenschaften haben und Im Hinblick auf die gewünschten Wirkungen evtl. inaktiv sind oder sogar negative Eigenschaften haben, kann deren Wirkungsprofil in Abhängigkeit von der Herstellungsmethode sowie von der Art der eingesetzten Rohstoffe erheblich variieren und sogar Wirkungen aufweisen, die völlig unerwünscht sind.

Dadurch dass die funktionalisierten Peptide und funktionalisierten Aminosäuren synthetisch hergestellt sind, stellt sich dieses Problem nicht. Indem nämlich einheitliche Verbindungen hergestellt werden, wird auch ein klar definiertes Wirkungsprofil erreicht.

Ferner wird das erwünschte Wirkungsprofil nur dann erreicht, wenn sich im Abscheidungsbad sowohl die synthetisch hergestellten funktionalisierten Peptide und/oder die synthetisch hergestellten funktionalisierten Aminosäuren, die mit Polyalkylenglykol- und/oder mit Polyalkylenimin- und/oder mit Polyvinylalkohol-Gruppen funktionalisiert sind, als auch mindestens eine Brightener-Verbindung, die ausgewählt ist aus der Gruppe umfassend organische Thiol-, Sulfid-, Disulfid- und Polysulfid-Verbindungen, befinden. Erst das Zusammenspiel der Peptide bzw. Aminosäuren mit dem Brightener ergibt den gewünschten Effekt. Abgesehen davon, dass das Abscheidungsbad von US 2002/0195351 A1 keine funktionalisierten Peptide oderfunktionalisierten Aminosäuren enthält, sondern bestimmte Aminosäuren, nämlich Schwefel enthaltende Aminosäuren, die unfunktionalisiert sind, enthält das Abscheidungsbad von US 2002/0195351 A1 außerdem auch keine Brightener-Verbindung. Somit weist dieses Bad nicht die gewünschten Eigenschaften auf.

Besonders bevorzugt ist es, wenn die Peptide Oligopeptide sind. Derartige Verbindungen enthalten vorzugsweise 2-10, ganz bevorzugt 2-4 Aminosäureeinheiten. Insbesondere derartige Verbindungen sind geeignet, die gewünschte Wirkung hervorzurufen. Ganz besonders bevorzugt sind Dipeptide und gegebenenfalls Tripeptide und Tetrapeptide. In dem erfindungsgemäßen wässrigen sauren Bad können auch Gemische dieser Verbindungen enthalten sein.

Weiter bevorzugt sind funktionalisierte Peptide, bei denen sich am C-Terminus eine End-Aminosäure befindet, die ausgewählt ist aus der Gruppe, umfassend Leucin, Isoleucin, Methionin, Phenylalanin, Tryptophan, Asparagin, Glutamin, Thyrosin, Lysin, Arginin, Histidin.

Weiter bevorzugt sind funktionalisierte Peptide gemäß der vorliegenden Erfindung, die mindestens eine beta-Aminosäure enthalten, die ausgewählt ist aus der Gruppe, umfassend beta-Alanine, beta-Phenylalanin, beta-Tryptophan, beta-Thyrosin, beta-Leucin, beta-Isoleucin, beta-Glutamin, beta-Glutaminsäure, beta-Histidin, beta-Methionin, Asparaginsäure.

Diese vorstehend genannten Verbindungen zeigen moderate BMV-Fülleigenschaften. Im Gegensatz zu herkömmlichen Levelern verursachen diese Verbindungen einen geringeren ski-slope als herkömmliche Leveller. Dieser Effekt kann genutzt werden, um in einem erfindungsgemäßen Bad die Line shape (das Oberflächenprofil) gezielt zu beeinflussen, ohne dass das BMV-Füllen beeinträchtigt wird.

Bevorzugte Polyalkylenglykol- und Polyalkylenimin-Gruppen sind Reste, die die allgemeine chemische Formel -(X-CHR-CH$_2$)$_n$-R' haben, wobei X O oder NH ist, R H oder Methyl ist, jedes X und jedes R in einem (X-CHR-CH$_2$) unabhängig von jedem X und R in einem anderen (X-CHR-CH$_2$) gewählt werden können, n eine ganze Zahl von 2 bis 1000 ist und R' H, Alkyl oder Aryl ist. R' ist vorzugsweise H. Wenn R' Alkyl ist, kann Alkyl insbesondere C$_1$-C$_8$-Alkyl sein. Wenn R' Aryl ist, kann Aryl insbesondere C$_5$-C$_{12}$-Aryl sein (wobei nur die Anzahl der aromatischen Ringkohlenstoffatome angegeben ist).

Vorteilhaft ist ferner, wenn -(X-CHR-CH$_2$)$_n$-R' aus der Gruppe ausgewählt ist, umfassend Homo-Polyethylenglykol-Radikale. Homo-Polypropylenglykol-Radikale, Homo-Polyethylenimin-Radikale und Copolymer-Radikale aus mindestens zwei Einheiten, ausgewählt aus der Gruppe, umfassend Ethylenglykol-, Propylenglykol- und Ethylenimin-Einheiten. Insbesondere können die Copolymer-Radikale alternierende, statistische, Gradienten-. Block- und Pfropf-Copolymer-Radlkale sein. Insbesondere bevorzugt sind Blockcopolymer-Radikale, die Ethylenglykol- und Propylenglykol-Einheiten enthalten.

Beispielsweise kann -(X-CHR-CH$_2$)$_n$-R' folgende Reste darstellen: -(O-CH$_2$CH$_2$)$_n$-H, -(O-CH(CH$_3$)-CH$_2$)$_n$-H. -(N-CH$_2$-CH$_2$)$_n$-H.

Der Rest -(X-CHR-CH$_2$)-R' kann ein mittleres Molekulargewicht von 300 bis 35.000 Dalton, vorzugsweise von 800 bis 15.000 Dalton haben. n liegt vorzugsweise in einem Bereich von 20 bis 500.

Aminosäuren und/oder Peptide mit Polyvinylalkohol-Resten können sich bevorzugt durch Reaktion von Polyvinylalkohol mit Aminosäuren und/oder Peptiden bilden.

Die Konzentration aller Leveler-Verbindungen zusammen in dem erfindungsgemäßen Bad beträgt vorzugsweise mindestens 0,01 mg/l, besonders bevorzugt mindestens 0,1 mg/l und am meisten bevorzugt mindestens 0,2 mg/l. Die Leveler-Konzentration beträgt vorzugsweise höchstens 1000 mg/l, besonders bevorzugt höchstens 10 mg/l und am meisten bevorzugt höchstens 2 mg/l. Diese Werte für die Untergrenze und für die Obergrenze können beliebig miteinander kombiniert werden.

Das erfindungsgemäße wässrige saure Bad enthält ferner zusätzlich mindestens eine Brightener (Glanzbildner)-Verbindung, die ausgewählt ist aus der Gruppe umfassend organische Thiol-, Sulfid-, Disulfid- und Polysutfid-Verbindungen. Ganz besonders bevorzugt ist mindestens eine Brightener-Verbindung, die ausgewählt ist aus der Gruppe, umfassend 3-(Benzthiazolyl-2-thio)-propylsulfonsäure, 3-Mercaptopropan-1-sulfonsäure, Ethytendithiodipropylsulfonsäure, Bis-(p-suffophenyl)-disulfid, Bis-(w-sulfobutyl)-disulfid, Bis-(ω-sulfohydroxypropyl)-disuifid, Bis-(ω-sulfopropyl)-disulfid, Bis-(ω-sulfopropyl)-sulfid, Methyl-(ω-sulfopropyl)-disulfid. Mothyl-(ω-sulfopropyl)-trisulfid, O-Ethyl-dithiokohlensäure-S-(ω-sulfopropyl)-ester, Thioglykolsäure, Thiophosphorsäure-O-ethyl-bis-(ω-sulfopropyl)-ester, Thiaphosphorsäure-tris-(ω-sulfopropyl)-ester sowie deren Salze.

Die Konzentration aller Brightener-Verbindungen zusammen in dem erfindungsgemäßen wässrigen sauren Bad beträgt vorzugsweise mindestens 0,01 mg/l, besonders bevorzugt mindestens 0,05 mg/l und am meisten bevorzugt mindestens 0,1 mg/l. Die Brightener-Konzentration beträgt vorzugsweise höchstens 100 mg/l, besonders bevorzugt höchstens 10 mg/l und am meisten bevorzugt höchstens 2 mg/l. Diese Werte für die Untergrenze und für die Obergrenze können beliebig miteinander kombiniert werden.

Ferner kann das erfindungsgemäße wässrige saure Bad zusätzlich mindestens eine Carrier-Substanz enthalten. Derartige Verbindungen können beispielsweise Sauerstoff enthaltende hochmolekulare Verbindungen sein. Hierbei handelt es sich vorzugsweise um eine Polyalkylenglykol-Verbindung, beispielsweise einen Polyalkylenglykol oder einen Säureester, insbesondere einen Carbonsäureester eines Polyalkylenglykols oder einen Ether aus einem Polyalkylenglykol und einem oder mehreren Alkoholen, wie einen Alkanolether oder einen Phenolether eines Poiyalkylenglykals. Derartige Additive sind beispielsweise: Polyvinylalkohol, Carboxymethylcellulose, Polyeihyienglykol, Polypropylenglykol, Stearinsäurepolyglykolester, Ölsäurepolyglykolester, Stearylalkoholpolyglykoiether, Nonylphenolpolyglykolether, Octanolpolyalkylenglykolether, Octanediol-bis-(polyalkylanglykolother), Poly(ethylenglykol-*ran*-propylenglykol), Poly(ethylenglykol)-*block*-poly(propylenglykol)-*block*-poly(ethylenglykol), Poly(propylenglykol)-block-poly(ethylenglykol)-*block*-poly(propylenglykol). Die Konzentration dieser Verbindungen beträgt vorzugsweise mindestens etwa 0,005 g/l, besonders bevorzugt mindestens etwa 0,01 g/l. Die Konzentration beträgt höchstens etwa 20 g/l, besonders bevorzugt höchstens etwa 5 g/l. Diese Werte für die Untergrenze und für die Obergrenze können beliebig miteinander kombiniert werden.

Das Kupferbad enthält eine Kupferionenquelle, beispielsweise Kupfersulfat, sowie ferner eine die elektrische Leitfähigkeit des Bades erhöhende Verbindung, beispielsweise Schwefelsäure, als Säureionenquelle und kann üblicherweise ein Chlorid enthalten. Diese Grundzusammensetzung des Bades kann in weiten Grenzen variiert werden. Im Allgemeinen wird eine wässrige Lösung mit folgender Zusammensetzung benutzt: Kupfersulfat (CuSO$_4$ 5H$_2$O): 20 bis 250 g/l, vorzugsweise 60 bis 80 g/l oder 180 bis 220 g/l; Schwefelsäure: 50 bis 350 g/l, vorzugsweise 180 bis 220 g/l oder 50 bis 90 g/l; Chloridionen: 0,01 bis 0,18 g/l, vorzugsweise 0.03 bis 0,10 g/l.

Anstelle von Kupfersulfat als Kupferionenquelle können zumindest teilweise auch andere Kupfersalze benutzt werden. Auch die Schwefelsäure kann teilweise oder ganz durch Fluoroborsäure, Methansulfonsäure oder andere Säuren ersetzt werden. Die Chloridionen werden als Alkalichlorld (beispielsweise Natriumchlorid) oder in Form von Salzsäure zugesetzt. Die Zugabe von Natriumchlorid kann ganz oder teilweise entfallen, wenn in den Zusätzen bereits Halogenidionen enthalten sind.

Außerdem können im Bad übliche Netzmittel oder weitere übliche Zusätze enthalten sein.

Zur Herstellung des Bades werden die Zusatzstoffe und anderen Zusätze der Grundzusammensetzung hinzugefügt. Die Arbeitsbedingungen des Bades sind vorzugsweise wie folgt: pH-Wert: 0 bis 3; Temperatur. 15°C - 50°C, besonders bevorzugt 15°C - 40°C; kathodische Stromdichte: 0,5 -12 A/dm$^2$, besonders bevorzugt 0,7 - 7 A/dm$^2$ (mittlere Stromdichte).

Das Abscheidebad kann insbesondere durch starke Anströmung und gegebenenfalls durch Einblasen von sauberer Luft derart bewegt werden, dass sich die Badoberfläche in starker Bewegung befindet Dadurch wird der Stofftransport in der Nähe der Kathoden und Anoden maximiert, so dass eine größere Stromdichte ermöglicht wird. Auch eine Bewegung der Kathoden bewirkt eine Verbesserung des Stofftransportes an den jeweiligen Oberflächen. Ferner kann auch eine Konvektion im Bad dadurch hervorgerufen werden, dass das Werkstück, beispielsweise ein Halbleiterwafer, mit relativ hoher Geschwindigkeit im Bad rotiert, so dass sich eine Sogwirkung hin zu dessen Oberfläche einstellt. Durch die erhöhte Konvektion und Elektrodenbewegung wird eine konstante diffusionskontrollierte Abscheidung erzielt. Das Werkstück kann horizontal, vertikal und/oder durch Vibration bewegt werden. Eine Kombination mit der Lufteinblasung in das Abscheidebad ist besonders wirksam.

Das beim Abscheideprozess verbrauchte Kupfer kann elektrochemisch über Kupferanoden ergänzt werden. Beispielsweise kann für die Anoden Kupfer mit einem Gehalt von 0,02 bis 0,067 Gel.-% Phosphor verwendet werden. Sie können direkt in den Elektrolyten eingehängt werden oder in Form von Kugeln oder Stücken verwendet und hierzu in TItankörbe, die sich im Bad befinden, eingefüllt werden.

Alternativ können unlösliche Anoden eingesetzt werden. Derartige Anoden sind während des Abscheideprozesses inert und verändern daher ihre Form nicht. Dies ermöglicht eine zeitlich konstante Geometrie bei der Abscheidung. Als unlösliche Anoden kommen insbesondere Edelmetalle, wie Platin, oder auch so, genannte Ventilmetalle, wie Titan, in Betracht, die mit Mischoxiden von Edelmetallen beschichtet sind, beispielsweise mit einer Beschichtung aus Rutheniumoxid und Indiumoxid. Die unlöslichen Anoden können in Form von Streckmetall vorliegen. Um bei Verwendung von unlöslichen Anoden eine Ergänzung der Kupferionen zu erreichen, kann eine Kupferverbindung in dem Bad aufgelöst werden, oder metallisches Kupfer wird mit dem erfindungsgemäßen wässrigen sauren Kupferbad in Kontakt gebracht. Dieses Metall löst sich unter der Einwirkung von in dem Bad gelöstem Sauerstoff oder mit Hilfe von Verbindungen auf, die die oxidierte Form eines Redoxsystems bilden, beispielsweise mit Hilfe von in dem Bad gelösten Fe(III)-Ionen, die dadurch zu Fe(II)-Ionen reduziert werden. Die Fe(II)-Ionen werden an der unlöslichen Anode wieder zu Fe(III)-Ionen oxidiert. Die Fe(II)/Fe(III)-Ionen können beispielsweise von dem entsprechenden Eisensulfatsalz stammen. Die Kon-zentration der Fe(II)-Ionen beträgt vorzugsweise 8-12 g/l und die der Fe(III)-Ionen bevorzugt 1- 5 g/l.

Anstelle eines Gleichstrom-(DC)-Verfahrens kann die Verkupferung auch mit einem Pulsstromverfahren durchgeführt werden. Derartige Pulsstrornvertahren umfassen unipolare Pulsstromverfahren, bei denen der Abscheidestrom regelmäßig unterbrochen wird und bei denen sich zwischen den Abscheidepulsen Strompausen befinden, sowie Pulsumkehrverfahren (Reverse-Puls-Plating), bei denen der Strom am Werkstück während der Metallisierung zeitweise umgekehrt, d.h. anodisch geschaltet, wird. Das Reverse-Puls-Plating wurde für die elektrolytischen Abscheidung insbesondere von Kupfer auf Leiterplatten mit einem hohen Aspektverhältnis entwickelt und ist beispielsweise in DE 42 25 961 C2 und DE 27 39 427 A1 beschrieben. Bei Anwendung hoher Stromdichten wird so eine verbesserte Oberflächenverteilung und Streuung in den Durchgangslöchern erreicht.

Kupfer kann sowohl in herkömmlicher Art und Weise durch Eintauchen des Werkstückes in ein sich in einem Tauchbadbehälter befindendes Abscheidebad und Polarisieren des Werkstückes gegenüber einer sich in demselben Bad befindenden Anode abgeschieden werden als auch in einem horizontalen Abscheideverfahren. Letztere Abscheideverfahren werden in horizontalen Durchlaufanlagen durchgeführt, durch die die Werkstückes in horizontaler Lage und Transportrichtung hindurch befördert und dabei mit dem Abscheidebad in Kontakt gebracht werden. Die Anoden sind ebenfalls in horizontaler Lage in der Anlage angeordnet und zwar entlang dem Transportweg für die Werkstücke. Derartige Anlagen sind beispielsweise in DE 36 24 481 A1 und DE 32 36 545 A1 offenbart. Weiterhin werden Wafer vorzugsweise in sogenannten Cup-Platem behandelt, in denen jeweils ein Wafer in horizontaler Lage oberhalb einer ebenfalls in horizontaler Lage angeordneten Anode angeordnet ist. Der-Cup-Plater ist mit dem Abscheidebad gefüllt. Somit stehen sowohl der Wafer als auch die Anode mit dem Abscheidebad in Kontakt. Der Wafer rotiert während der Abscheidung.

Die folgenden Beispiele und Vergleichsbeispiele dienen zur Erläuterung der Erfindung:

Fig. 1    zeigt ein Test-Layout für eine Leiterplatte, die zur Durchführung der Versuche verwendet wurde: Fig. 1a: Plattenaufbau, Fig. 1 b: Lochmuster (mit Fig.1 b1: lin- ke obere Ecke des Layouts und Fig. 1 b2: rechte obere Ecke des Layouts);

Fig. 2    zeigt eine schematische Querschnittsdarstellung eines mit Kupfer gefüllten BMV', das einen Dimple aufweist;

Fig. 3    zeigt eine schematische Querschnittsdarstellung eines mit Kupfer gefüllten Trench' in einem Photoresist;

Fig. 4    zeigt eine Querschnittsaufnahme durch ein BMV, das mit Kupfer gefüllt ist;

Fig. 5    zeigt ein gefülltes BMV und einen gefüllten Trench (Vergleichsversuch);

Fig. 6    zeigt ein gefülltes BMV und einen gefüllten Trench (erfindungsgemäßer Ver- such).

Experimentelle Durchführung für alle Versuche:

Equipment: Cornellzelle 1,8 Liter; Badbewegung mit Pumpe; keine Lufteinblasung.

Badzusammensetzung: 50 g/l $Cu^{2+}$ (als Kupfersulfat); 150 g/l $H_2SO_4$; 45 mg/l $Cl^-$ (als Natriumchlorid); 100 mg/l $Fe^{2+}$ (als Eisen(II)sulfat); 300 mg/l PEG 10.000; 0,1 ml/l einer Schwefel enthaltenden Glanzbildnerlösung; 0 - 3 mg/l Leveler.

Plating-Parameter: 2 A Zellstrom; 67 min Platingzeit; 90 min @ 2 A; Dummyplating vor Beginn der Experimente zur Einarbeitung des Bades.

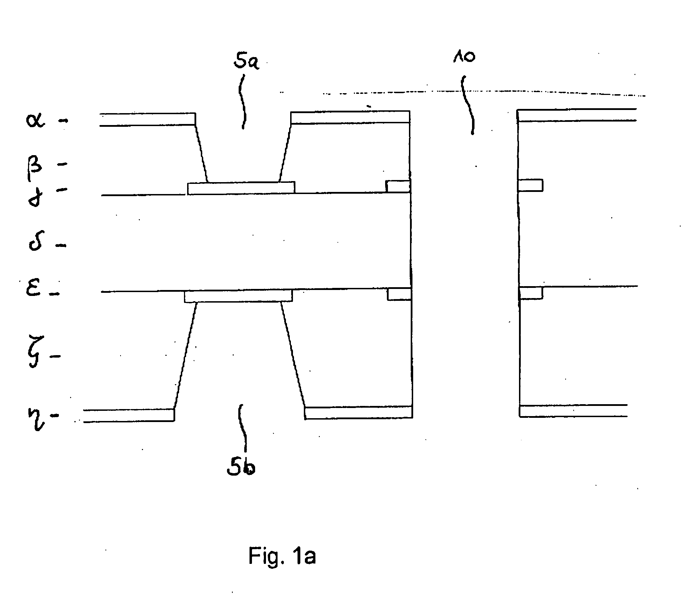

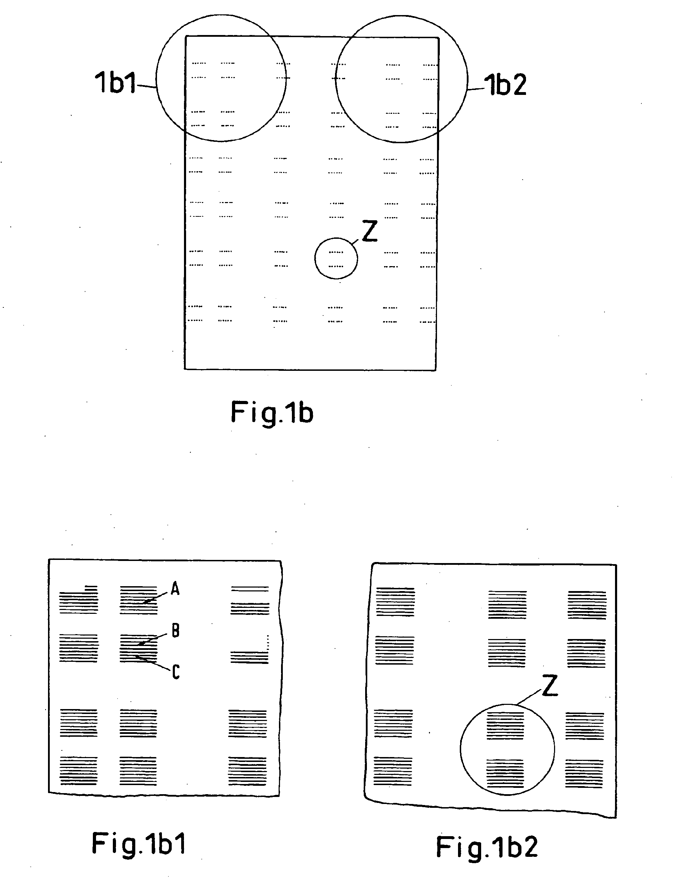

Panelparameter: 620 mm x 457 mm große, 1,5 mm dicke FR4-Test-Leiterplatke mit vier Lagen mit Durchgangslöchern und BMVs in Gruppen mit den Größen: Durchgangslöcher 10 (Durchmesser): 250 $\mu$m (Position A); BMVs 5a, 5b: (Durchmesser x Tiefe) 150 $\mu$m x 60 $\mu$m (Position B), 150 $\mu$m x 80 $\mu$m (Position C), 125 $\mu$m x 80 $\mu$m (Position C), 100 $\mu$m x 80 $\mu$m (Position C) (siehe Fig. 1b: Gesamtansicht und Detailansichten: linke obere Ecke: Ansicht Fig. 1b1, rechte obere Ecke: Ansicht Fig. 1 b2); Gesamtanzahl: 6480 BMVs, 1728 Durchgangslöcher; asymmetrischer Aufbau der Platte mit (von oben) 5 $\mu$m Kupferkaschierung ($\alpha$), 60 $\mu$m Prepreg ($\beta$), 18 $\mu$m Kupfer ($\gamma$), 1500 $\mu$m FR4-Kern (ö), 18 $\mu$m Kupfer ($\epsilon$), 80 $\mu$m Prepreg ($\zeta$), 5 $\mu$m Kupferkaschierung ($\eta$) (siehe Fig. 1a).

Ausführungsbeispiel 1 (zum Vergleich):

Leveler: $NH_2$-Gly-Leu-OH

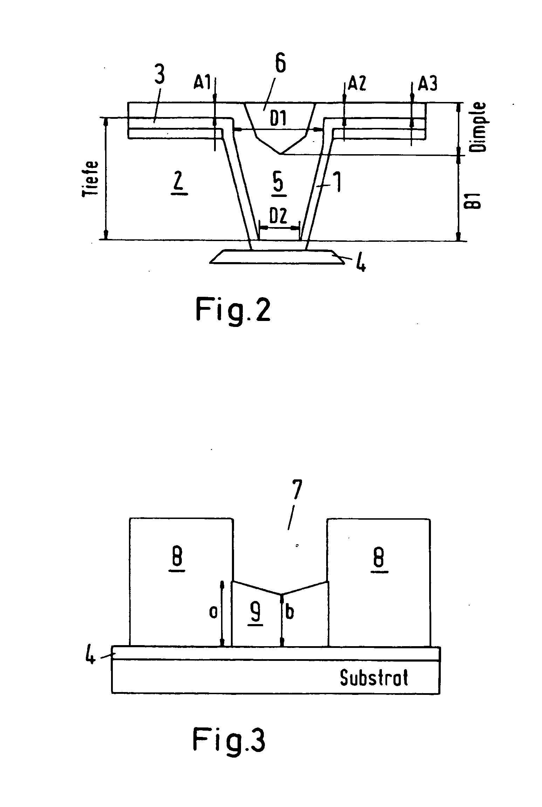

Die Leiterplatten wurden mit unterschiedlichem Levelergehalt im Bad mit Kupfer beschichtet. Zum Vergleich wurde zunächst ein Versuch ohne Leveler durchgeführt. Anschließend wurden erfindungsgemäße Versuche mit ansteigendem Levelergehalt durchgeführt. Die Auswertung erfolgte durch Entnahme von Schliffen an einer zuvor definierten Position auf der Leiterplatte. Als Maß für das Verfüllen eines BMV' wurde der Dimple verwendet. In Fig. 2 ist die Ermittlung dieser Prüfgröße schematisch gezeigt: Die mittels herkömmlicher Verfahren elektrisch leitend gemachte Wand eines BMV' ist mit 1 bezeichnet. Diese leitfähige Schicht geht auf der Oberfläche der angrenzenden Photoresistschicht 2 in eine Oberflächenmetallisierung 3 über, beispielsweise eine Leiterbahn. Der Fuß der Metallisierung in dem BMV steht mit einer Kupferlage 4 in elektrischem Kontakt. Das BMV ist mit dem erfindungsgemäßen Verfahren elektrolytisch mit Kupfer 5 gefüllt. Allerdings ist ein oberer Bereich 6 nicht mit Kupfer gefüllt (Dimple),
[0060]   Es werden folgende Größen ermittelt (die Parameter A1, A2, A3, B1 und Tiefe sind Fig. 2 zu entnehmen):

$$\text{Lochrandabflachung} = (1 - (\text{Mittelwert von A1 und A2}) / \text{A3}) \times 100$$

$$\text{Streuung (minimal)} = \text{B1} / (\text{Mittelwert von A1 und A2}) \times 100$$

$$\text{Füllverhältnis} = \text{B1} / (\text{Tiefe} + (\text{Mittelwert von A1 und A2}) \times 100$$

A1 und A2 werden in einem Abstand von 15 $\mu$m von der Lochkante aus ermittelt.
Der ski slope der Kupferoberfläche in einem gefüllten Trench ist Fig. 3 zu entnehmen. Dort ist ein Kanal 7 in einem Photoresist 8 gezeigt. Die untere Hälfte des Kanals ist mit Kupfer 9 gefüllt. Dieses Kupfer 9 steht mit einer Kupferlage 4 in elektrischem Kontakt.
Es wird folgende Größe ermittelt (die Parameter a und b sind Fig. 3 zu entnehmen):

$$\text{Ski slope [\%]} = ((b - a) / a) \times 100$$

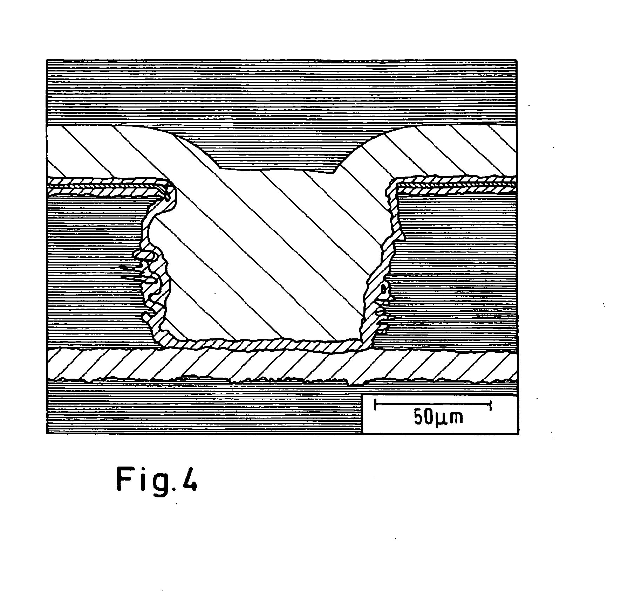

In Fig. 4 ist eine Querschnittsansicht durch ein BMV nach Metallisierung der Platte durch ein Loch mit einem

Durchmesser von 100 $\mu$m gezeigt. Die Konzentration des Levelers NH$_2$-Gly-Leu-OH betrug 0,3 mg/l.

Ausführungsbeispiel 2 (zum Vergleich):

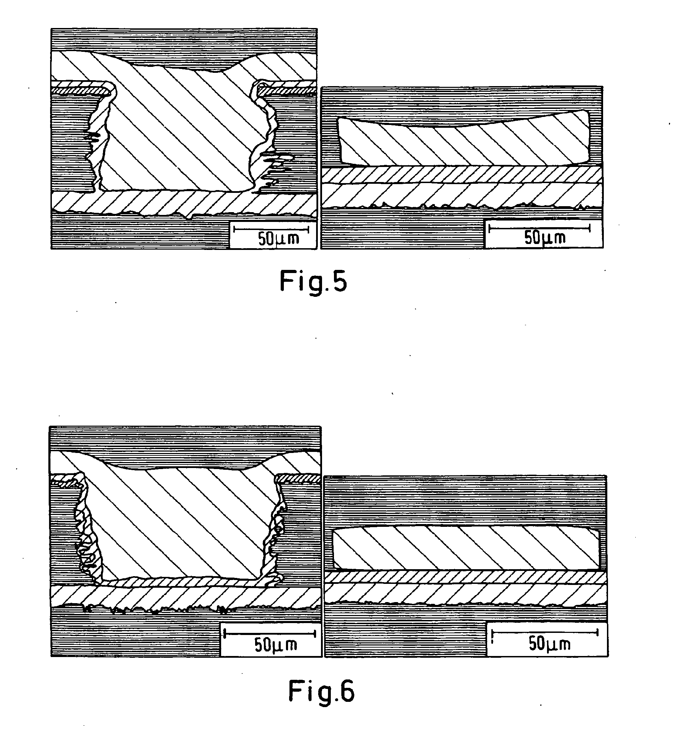

NH$_2$-Gly-Leu-OH zeigt BMV-Filling-Eigenschaften. Im Gegensatz zu herkömmlichen Levelern verursachen die Aminosäuren und Peptide jedoch niemals einen Ski-slope. Dieser vorteilhafte Effekt kann genutzt werden, um die Lineshape in Bädern zum Füllen von BMVs gezielt zu beeinflussen, ohne das BMV-Filling zu verschlechtem. Zur Untersuchung der Line shape wurde eine Testplatte verkupfert, die Kanäle aufwies, wie sie durch Photoresiste hervorgerufen werden. Diese Kanäle wurden unter den angegebenen Bedingungen mit Kupfer gefüllt, wobei als Leveler NH$_2$Gly-Leu-OH, wie in Ausführungsbeispiel 1 angegeben, verwendet wurde. Die Kupferschicht wuchs regelmäßig auf und bildete eine rechteckige Struktur im Graben (Fig. 6).
Dies wird jedoch mit herkömmlichen Levelern nicht beobachtet, die für das Via Filling üblicherweise verwendet werden. Für einen derartigen Vergleichsversuch wurde kein NH$_2$-Gly-Leu-OH als Leveler verwendet, sondern ein Cupracid® HL Bad von Atotech mit BMV-filling Eigenschaften. In diesem Falle war eine konkave Abscheidungsform zu beobachten (Fig. 5). Diese konkave Abscheidungsform ist für die nachfolgenden Prozessschritte einer Leiterplatte (CMP-Verfahren) sehr nachteilig und sollte daher unbedingt verhindert werden.

**Patentansprüche**

1. Wässriges saures Bad zum elektrolytischen Abscheiden von Kupfer, enthaltend mindestens eine Kupferionenquelle, mindestens eine Säureionenquelle, mindestens eine Brightener-Verbindung, die ausgewählt ist aus der Gruppe umfassend organische Thiol-, Sulfid-, Disulfid- und Palysulfid-Verbindungen, und mindestens eine Leveler-Verbindung, **dadurch gekennzeichnet, dass** mindestens eine Leveler-Verbindung ausgewählt ist aus der Gruppe, umfassend synthetisch hergestellte funktionalisierte Aminosäuren und synthetisch hergestellte funktionalisierte Peptide, und dass die Peptide und/oder Aminosäuren mit Polyalkylenglykol- und/oder mit Polyalkylenimin- und/oder mit Polyvinylalkohol-Gruppen funktionalisiert sind.

2. Wässriges saures Bad zum elektrolytischen Abscheiden von Kupfer nach Anspruch 1, **dadurch gekennzeichnet, dass** die Polyalkylenglykol- und/oder Polyalkylenimin-Gruppen die allgemeine chemische Formel -(X-CHR-CH$_2$)$_n$-R' haben, wobei X O oder NH ist. R H oder Methyl ist, jedes X und jedes R in einem (X-CHR-CH$_2$) unabhängig von jedem X und R in einem anderen (X-CHR-CH$_2$) gewählt werden können, n eine ganze Zahl von 2 bis 1000 ist und R' H, Alkyl oder Aryl ist.

3. Wässriges saures Bad zum elektrolytischen Abscheiden von Kupfer nach Anspruch 2, **dadurch gekennzeichnet, dass** -(X-CHR-CH$_2$)$_n$-R' aus der Gruppe ausgewählt ist, umfassend Homo-Polyethylenglykol-Radikale, Homo-Polypropylenglykol-Radikale, Homo-Polyethylenimin-Radikale und Copolymer Radikale aus mindestens zwei Einheiten, ausgewählt aus der Gruppe, umfassend Ethylenglykol-, Propylenglykol- und Ethytenimin-Einheiten.

4. Wässriges saures Bad zum elektrolytischen Abscheiden von Kupfer nach Anspruch 3, **dadurch gekennzeichnet, dass** die Copolymer-Radikale durch Blockcopolymere gebildet sind, umfassend Ethylengtykol- und Propylenglykol-Einheiten.

5. Wässriges saures Bad zum elektrolytischen Abscheiden von Kupfer nach einem der Ansprüche 2-4, **dadurch gekennzeichnet, dass** -(X-CHR-CH$_2$)$_n$-R' ein mittleres Molekulargewicht von 300 - 35.000 Dalton hat.

6. Wässriges saures Bad zum elektrolytischen Abscheiden von Kupfer nach einem der Ansprüche 2-5, **dadurch gekennzeichnet, dass** -(X-CHR-CH$_2$)$_n$-R' ein mittleres Molekulargewicht von 800-15.000 Dalton hat.

7. Wässriges saures Bad zum elektrolytischen Abscheiden von Kupfer nach einem der Ansprüche 2-6, **dadurch gekennzeichnet, dass** n 20 - 500 ist.

8. Wässriges saures Bad zum elektrolytischen Abscheiden von Kupfer nach einem der Ansprüche 2 - 7, **dadurch gekennzeichnet, dass** R' C$_1$-C$_8$-Alkyl oder C$_5$-C$_{12}$-Aryl ist.

9. Wässriges saures Bad zum elektrolytischen Abscheiden von Kupfer nach einem der Ansprüche 2-7. **dadurch gekennzeichnet, dass** R' H ist.

**10.** Wässriges saures Bad zum elektrolytischen Abscheiden von Kupfer nach einem der vorstehenden Ansprüche, **dadurch gekennzeichnet, dass** die Peptide Oligopeptide sind, enthaltend 2-10 Aminosäureeinheiten.

**11.** Wässriges saures Bad zum elektrolytischen Abscheiden von Kupfer nach einem der vorstehenden Ansprüche, **dadurch gekennzeichnet, dass** sich am C-Terminus mindestens eines funktionalisierten Peptids eine End-Aminosäure befindet, die ausgewählt ist aus der Gruppe, umfassend Leucin, Isoleucin, Methionin, Phenylalanin, Tryptophan, Asparagin, Glutamin, Thyrosin, Lysin, Arginin, Histidin.

**12.** Wässriges saures Bad zum elektrolytischen Abscheiden von Kupfer nach einem der Ansprüche 1 - 10, **dadurch gekennzeichnet, dass** das funktionalisierte Peptid mindestens eine beta-Aminosäure enthält, die ausgewählt ist aus der Gruppe, umfassend beta-Alanine, beta-Phenylalanin, beta-Tryptophan, beta-Thyrosin, beta-Leucin, beta-Isoleucin, beta-Glutamin, beta-Glutaminsäure, beta-Histidin, beta-Methionin, Asparaginsäure.

**13.** Verfahren zum elektrolytischen Abscheiden von Kupfer auf einem Werkstück, umfassend: (i) Bereitstellen des wässrigen sauren Bades zum elektrolytischen Abscheiden von Kupfer nach einem der Ansprüche 1-12 sowie mindestens eine Anode, (ii) In-Kontakt-Bringen des Werkstückes und mindestens einer Anode mit dem wässrigen sauren Bad und (III) Erzeugen eines elektrischen Stromflusses zwischen dem Werkstück und der mindestens einen Anode, so dass Kupfer auf dem Werkstück abgeschieden wird.

**14.** Verfahren zum elektrolytischen Abscheiden von Kupfer nach Anspruch 13, **dadurch gekennzeichnet, dass** das Werkstück eine Leiterplatte, ein Chip Carrier oder ein Halbleiterwafer ist.

**15.** Verfahren zum elektrolytischen Abscheiden von Kupfer nach einem der Ansprüche 13 und 14, **dadurch gekennzeichnet, dass** Kupfer in Trenches und BMVs der Leiterplatten, Chip Carrier oder Wafer abgeschieden wird.

**Claims**

**1.** An aqueous acidic bath for the electrolytic deposition of copper, containing at least one copper ion source, at least one acid ion source, at least one brightener compound which is selected from the group comprising organic thiol, sulphide, disulphide and polysulphide compounds, and at least one leveller compound, **characterised in that** at least one leveller compound is selected from the group comprising synthetically produced functionalised amino acids and synthetically produced functionalised peptides, and **in that** the peptides and/or amino acids are functionalised with polyalkylene glycol and/or polyalkyleneimine and/or polyvinyl alcohol groups.

**2.** The aqueous acidic bath for the electrolytic deposition of copper according to claim 1, **characterised in that** the polyalkylene glycol and/or polyalkyleneimine groups have the general chemical formula $-(X-CHR-CH_2)_n-R'$ wherein X is O or NH, R is H or methyl, each X and each R in a $(X-CHR-CH_2)$ can be selected independently from each X and R in another $(X-CHR-CH_2)$, n is an integer from 2 to 1,000 and R' is H, alkyl or aryl

**3.** The aqueous acidic bath for the electrolytic deposition of copper according to claim 2, **characterised in that** $-(X-CHR-CH_2)_n-R'$ is selected from the group comprising homopolyethylene glycol radicals, homopolypropylene glycol radicals, homopolyethyleneimine radicals and copolymer radicals of at least two units selected from the group comprising ethylene glycol, propylene glycol and ethyleneimine units.

**4.** The aqueous acidic bath for the electrolytic deposition of copper according to claim 3, **characterised in that** the copolymer radicals are formed by block copolymers comprising ethylene glycol and propylene glycol units.

**5.** The aqueous acidic bath for the electrolytic deposition of copper according to one of the claims 2-4, **characterised in that** $-(X-CHR-CH_2)_n-R'$ has an average molecular weight of 300-35,000 Dalton.

**6.** The aqueous acidic bath for the electrolytic deposition of copper according to one of the claims 2-5, **characterised in that** $-(X-CHR-CH_2)_n-R'$ has an average molecular weight of 800-15,000 Dalton.

**7.** The aqueous acidic bath for the electrolytic deposition of copper according to one of the claims 2-6, **characterised in that** n is 20-500.

**8.** The aqueous acidic bath for the electrolytic deposition of copper according to one of the claims 2-7, **characterised**

**in that** R' is $C_1$-$C_8$ alkyl or $C_5$-$C_{12}$ aryl.

9. The aqueous acidic bath for the electrolytic deposition of copper according to one of the claims 2-7, **characterised in that** R' is H.

10. The aqueous acidic bath for the electrolytic deposition of copper according to any one of the preceding claims, **characterised in that** the peptides are oligopeptides containing 2-10 amino acid units.

11. The aqueous acidic bath for the electrolytic deposition of copper according to any one of the preceding claims, **characterised in that** a terminal amino acid is located at the C-terminus of at least one functionalised peptide, the terminal amino acid being selected from the group comprising leucine, isoleucine, methionine, phenylalanine, tryptophan, asparagine, glutamine, thyrosine, lysine, arginine, histidine.

12. The aqueous acidic bath for the electrolytic deposition of copper according to one of the claims 1-10, **characterised in that** the functionalised peptide contains at least one beta-amino acid selected from the group comprising beta-alanine, beta-phenylalanine, beta-tryptophan, beta-thyrosine, beta-leucine, beta-isoleucine, beta-glutamine, beta-glutamic acid, beta-histidine, beta-methionine, aspartic acid.

13. A method for the electrolytic deposition of copper on a work piece, comprising: (i) providing the aqueous acidic bath for the electrolytic deposition of copper according to one of the claims 1-12 and at least one anode, (ii) contacting the work piece and at least one anode with the aqueous acidic bath, and (iii) generating an electrical current between the work piece and the at least one anode such that copper is deposited on the work piece.

14. The method for the electrolytic deposition of copper according to claim 13, **characterised in that** the work piece is a printed circuit board, a chip carrier or a semiconductor wafer.

15. The method for the electrolytic deposition of copper according to one of the claims 13 and 14, **characterised in that** copper is deposited in trenches and BMVs of the printed circuit boards, chip carriers or wafers.

**Revendications**

1. Bain acide aqueux pour le dépôt électrolytique de cuivre, contenant au moins une source d'ions cuivre, au moins une source d'ions acides, au moins un composé brillanteur, qui est choisi parmi le groupe comprenant des composés thiol, sulfure, disulfure et polysulfure organiques, et au moins un composé nivelant, **caractérisé en ce qu'**au moins un agent nivelant est choisi parmi le groupe comprenant des acides aminés fonctionnalisés synthétiques et des peptides fonctionnalisés synthétiques, et **en ce que** les peptides et/ou acides aminés sont fonctionnalisés avec des groupes polyalkylèneglycol et/ou polyalkylèneimine et/ou polyvinylalcol.

2. Bain acide aqueux pour le dépôt électrolytique de cuivre selon la revendication 1, **caractérisé en ce que** les groupes polyalkylèneglycol et/ou polyalkylèneimine ont la formule chimique générale -(X-CHR-CH$_2$)$_n$-R', où X est O ou NH, R est H ou méthyle, chaque X et chaque R d'un (X-CHR-CH$_2$) peuvent être choisis indépendamment d'un autre (X-CHR-CH$_2$), n est un nombre entier allant de 2 à 1000, et R' est H, alkyle ou aryle.

3. Bain acide aqueux pour le dépôt électrolytique de cuivre selon la revendication 2, **caractérisé en ce que** -(X-CHR-CH$_2$)$_n$-R' est choisi parmi le groupe comprenant les radicaux homopolyéthylèneglycol, les radicaux homopolypropylèneglycol, les radicaux homopolyéthylèneimine et les radicaux copolymères constitués d'au moins deux unités choisies parmi le groupe comprenant les unités éthylèneglycol, propylèneglycol et éthylèneimine.

4. Bain acide aqueux pour le dépôt électrolytique de cuivre selon la revendication 3, **caractérisé en ce que** les radicaux copolymères sont formés par des copolymères séquencés, comprenant des unités éthylèneglycol et propylèneglycol.

5. Bain acide aqueux pour le dépôt électrolytique de cuivre selon l'une des revendications 2-4, **caractérisé en ce que** -(X-CHR-Ch$_2$)$_n$-R' a un poids moléculaire moyen allant de 300 à 35 000 Dalton.

6. Bain acide aqueux pour le dépôt électrolytique de cuivre selon l'une des revendications 2-5, **caractérisé en ce que** -(X-CHR-CH$_2$)$_n$-R' a un poids moléculaire moyen allant de 800 à 15 000 Dalton.

7. Bain acide aqueux pour le dépôt électrolytique de cuivre selon l'une des revendications 2-6, **caractérisé en ce que** n vaut 20 à 500.

8. Bain acide aqueux pour le dépôt électrolytique de cuivre selon l'une des revendications 2-7, **caractérisé en ce que** R' est alkyle en $C_1$-$C_8$ ou aryle est $C_5$-$C_{12}$.

9. Bain acide aqueux pour le dépôt électrolytique de cuivre selon l'une des revendications 2-7, **caractérisé en ce que** R' est H.

10. Bain acide aqueux pour le dépôt électrolytique de cuivre selon l'une des revendications précédentes, **caractérisé en ce que** les peptides sont des oligopeptides contenant 2 à 10 unités acide aminé.

11. Bain acide aqueux pour le dépôt électrolytique de cuivre selon l'une des revendications précédentes, **caractérisé en ce que** un acide aminé terminal se trouve sur l'extrémité C d'au moins un peptide fonctionnalisé, lequel acide aminé terminal est choisi parmi le groupe comprenant la leucine, l'isoleucine, la méthionine, la phénylalanine, le tryptophane, l'asparagine, la glutamine, la tyrosine, la lysine, l'arginine, l'histidine.

12. Bain acide aqueux pour le dépôt électrolytique de cuivre selon l'une des revendications 1-10, **caractérisé en ce que** le peptide fonctionnalisé contient au moins un acide bêta-aminé, qui est choisi parmi le groupe comprenant la bêta-alanine, la bêta-phénylalanine, le bêta-tryptophane, la bêta-tyrosine, la bêta-leucine, la bêta-isoleucine, la bêta-glutamine, le bêta-acide glutamique, la bêta-histidîne, la bêta-méthionine, l'acide aspartique.

13. Procédé pour le dépôt électrolytique de cuivre sur une pièce, comprenant : (i) la préparation du bain acide aqueux pour la dépôt électrolytique du cuivre selon l'une des revendications 1-12, ainsi qu'au moins une anode, (ii) la mise en contact de la pièce et d'au moins une anode avec le bain acide aqueux, et (iii) la production d'un courant électrique entre la pièce et la au moins une anode de sorte que le cuivre se dépose sur la pièce.

14. Procédé pour le dépôt électrolytique de cuivre selon la revendication 13, **caractérisé en ce que** la pièce est une plaque conductrice, un support de puce et/ou une tranche semi-conductrice.

15. Procédé pour le dépôt électrolytique de cuivre selon les revendications 13 et 14, **caractérisé en ce que** le cuivre est déposé dans des tranchées et trous borgnes de plaques conductrices, supports de puce ou tranches.

EP 2 113 587 B1

α –

β –
γ –

δ –

ε –

ζ –

η –

5a

10

5b

Fig. 1a

Fig.1b

Fig.1b1

Fig.1b2

Fig.2

Fig.3

**Fig.4**

Fig.5

Fig.6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2876178 A
- US 5972192 A
- US 6261433 B
- US 5215645 A
- US 20040188263 A1
- US 20020195351 A1
- US 200410188263 A1
- DE 4225961 C2
- DE 2739427 A1
- DE 3624481 A1
- DE 3236545 A1

**In der Beschreibung aufgeführte Nicht-Patentliteratur**

- **P.M.Vereecken et al.** The chemistry of additives in damascene copper plating. *IBM J. Res. & Dev.,* Januar 2005, vol. 49 (1), 3-18
- **beispielsweise F. Albericio.** Developments in peptide and amide synthesis. *Current Opinion in Chemical Biology,* 2004, vol. 8, 211-221
- **F. M. Veronese.** Peptide and protein PEGylation: a review of problems and solutions. *Biomaterials,* 2001, vol. 22, 405-417